# EUROPEAN PATENT SPECIFICATION

(11) **EP 3 508 332 B1**
(45) Date of publication and mention of the grant of the patent: **27.01.2021**
(21) Application number: 18215971.5
(22) Date of filing: 31.12.2018
(51) Int. Cl.: B29C 64/135, B33Y 30/00

(54) **3D PRINTER WITH COOLING FUNCTION**
3D-DRUCKER MIT KÜHLFUNKTION
IMPRIMANTE 3D AVEC FONCTION DE REFROIDISSEMENT

(30) Priority: 04.01.2018 KR 20180001066
(43) Date of publication of application: 10.07.2019
(73) Proprietor: Sindoh Co., Ltd., Seongdong-gu Seoul 04797 (KR)
(72) Inventor: LEE, Byoung-bag, 03303 Seoul (KR); PARK, Ji-sung, 04984 Seoul (KR); HAN, Seung-won, 04425 Seoul (KR)
(74) Representative: Jacobacci Coralis Harle

(56) References cited:
- WO-A1-2015/079839
- CN-A- 106 827 509
- CN-B- 105 109 048
- CN-U- 205 929 484
- KR-B1- 101 671 840
- KR-B1- 101 800 667
- US-A1- 2016 297 141

## Description

### BACKGROUND OF THE INVENTION

### 1. Field of the invention

The present disclosure relates to a three-dimensional ("3D") printer using a linear laser light source that shapes a three-dimensional object by projecting laser light to a photocurable liquid resin and, more particularly, to a 3D printer having a cooling function for cooling a linear laser light source.

### 2. Description of the Prior Art

Generally, in order to produce a prototype having a 3D shape, a mockup manufacturing method and a CNC milling-based manufacturing method and the like are widely known. Document CN205929484 describes a cooling system for photocuring 3D printer Document US 2016 297141 A1 shows an apparatus and method for making a three-dimensional object from a solidifiable material using a linear solidification device.

However, the mockup manufacturing method is manually performed, and thus it is difficult to perform precise numerical control and it takes a lot of time to perform the method. Although the CNC milling-based manufacturing method is capable of performing precise numerical control, there are many products difficult to process using the CNC milling-based manufacturing method due to tool interference.

In recent years, a so-called 3D printing method has appeared in which a product designer creates 3D modeling data using CAD or CAM, and a prototype having a 3D shape using the generated data is manufactured. Such a 3D printing method is used in various fields such as industry, life, and medical science.

A 3D printer is an apparatus for manufacturing an object by outputting successive layers of a material like a 2D printer and stacking the successive layers. Such a 3D printer is capable of manufacturing an object quickly based on digitized drawing information and is mainly used for manufacturing a prototype sample or the like.

Product molding methods using a 3D printer include a photocurable resin shaping method using a Stereo Lithography Apparatus (SLA), in which a photocurable material is scanned using laser light so as to shape the portion scanned by the laser light into an object, or a Selective Laser Melting Method (SLM), in which a thermoplastic filament is melted and stacked.

In the molding methods using a 3D printer, a photocurable-resin-shaping-type 3D printer is configured to mold a 3D object by projecting laser light to a tank in which the photocurable liquid resin is stored so as to cure the liquid resin.

Here, a light projection device for projecting laser light is configured such that a galvanometer mirror is installed between a laser light source and a bed in which a 3D object is molded and this 3D object is molded while performing X-Y axis control of the galvanometer mirror and simultaneously performing Z-axis control of the bed.

However, in such a conventional 3D printer, the size of the light projection device is increased due to the structure of the galvanometer mirror subjected to the X-Y axis control, and the configuration of the controller becomes complicated due to the control of the galvanometer mirror and the bed.

Further, a large amount of heat is generated from the laser light projection device, and thus a device for cooling the laser light projection device without greatly increasing its overall size is demanded.

### SUMMARY OF THE INVENTION

The present disclosure has been made in order to solve the problems described above, and an aspect of the present disclosure is to provide a 3D printer having a cooling function capable of minimizing the size of the device and removing heat generated from a light source.

In accordance with the aspects described above, the present invention, as disclosed in claim 1, provides a 3D printer having a cooling function. The 3D printer includes: a tank configured to store therein a photocurable liquid resin; a bed configured to be moveable in a vertical direction within the tank and to support a shaping object; a bed transfer unit configured to move the bed in the vertical direction; a light projection unit configured to linearly project laser light to the photocurable liquid resin stored in the tank in a longitudinal direction of the tank so as to cure the photocurable liquid resin into the shaping object; a light projection unit transfer unit configured to move the light projection unit in a width direction of the tank; a control unit configured to control operations of the light projection unit, the light projection unit transfer unit, and the bed transfer unit; and a cooling unit installed on one side of the light projection unit and configured to dissipate heat generated from the light projection unit.

The light projection unit includes: a light projection unit main body fixed to the light projection unit transfer unit so as to be transferred in the width direction of the tank; a laser diode embedded in the light projection unit main body and configured to project laser light in one direction; a polygon mirror embedded in the light projection unit main body and configured to linearly reflect the laser light projected from the laser diode in the longitudinal direction of the tank while rotating; and a refraction mirror installed within the light projection unit main body and configured to refract the laser light reflected from the polygon mirror to the photocurable liquid resin within the tank.

In addition, the light projection unit may further include: a cylindrical lens configured to condense the laser light projected from the laser diode on a reflection surface of the polygon mirror; a first F-θ Lens installed between the polygon mirror and the refraction mirror and configured to condense the laser light reflected from a reflection surface of the polygon mirror toward the tank; and a second F-θ Lens installed between the first F-θ lens and the refraction mirror and configured to condense the laser light reflected from a reflection surface of the polygon mirror toward the tank.

The polygon mirror includes a rotation shaft disposed perpendicular to a surface of the liquid resin within the tank so as to have a rotation plane parallel to the surface of the liquid resin

The light projection unit may further include: a beam-detecting sensor configured to receive the laser light reflected from the polygon mirror so as to determine an output start position of image data of the shaping object; and a beam-detecting mirror configured to reflect the laser light reflected from the polygon mirror to the beam-detecting sensor.

A plurality of laser diodes may be provided so as to be spaced apart from each other at a predetermined interval in a circumferential direction around one point of the polygon mirror, and the plurality of laser diodes may project laser light such that the laser light is superimposed on the one point of the polygon mirror.

The cooling unit may include a heat dissipation fan provided on a plate on one side of the light projection unit main body and a Peltier thermoelectric element provided between the plate and the heat dissipation fan and configured to absorb heat from the plate and to discharge heat through the heat dissipation fan.

Here, the cooling unit may further include a heat sink installed between the Peltier thermoelectric element and the heat dissipation fan, and the heat sink may be fixed onto the plate by a bolt made of a plastic material, and the plate may be made of a metal material.

A 3D printer having a cooling function according to the present disclosure has a structure in which the laser beam projected from the light projection unit moves in the horizontal direction while being formed linearly. Thus, it is possible to simplify the structure of the apparatus, compared with the conventional type in which X-Y axis control is performed on the galvanometer mirror, whereby it is possible to reduce the projecting time of laser light and thus to reduce the shaping time of a 3D object.

According to the present disclosure, a cooling unit is provided on one side of the light projection unit main body. Thus, heat generated from the light projection unit can be dissipated effectively.

### BRIEF DESCRIPTION OF THE DRAWINGS

The above and other aspects, features, and advantages of the present disclosure will be more apparent from the following detailed description taken in conjunction with the accompanying drawings, in which:
FIG. 1 is a perspective view illustrating a 3D printer having a cooling function according to the present disclosure;
FIG. 2 is a perspective view of the 3D printer having a cooling function according to the present disclosure, which is viewed in another direction;
FIG. 3 is a front view illustrating the 3D printer having a cooling function according to the present disclosure;
FIG. 4 is a side view illustrating the 3D printer having a cooling function according to the present disclosure;
FIG. 5 is a perspective view illustrating a bed and a bed transfer unit of the 3D printer having a cooling function according to the present disclosure;
FIG. 6 is a perspective view illustrating a light projection unit transfer unit of the 3D printer having a cooling function according to the present disclosure;
FIG. 7 is a perspective view illustrating a light projection unit of the 3D printer having a cooling function according to the present disclosure;
FIG. 8 is a perspective view illustrating the inside of a light projection unit of the 3D printer having a cooling function according to the present disclosure; and
FIG. 9 is a perspective view illustrating a cooling device of a light projection unit of the 3D printer having a cooling function according to the present disclosure.

### DETAILED DESCRIPTION OF THE EXEMPLARY EMBODIMENTS

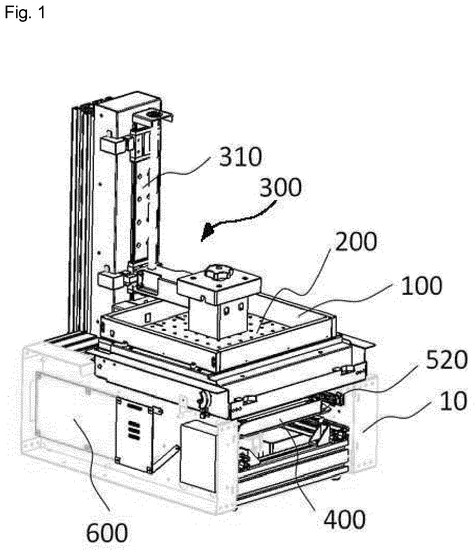

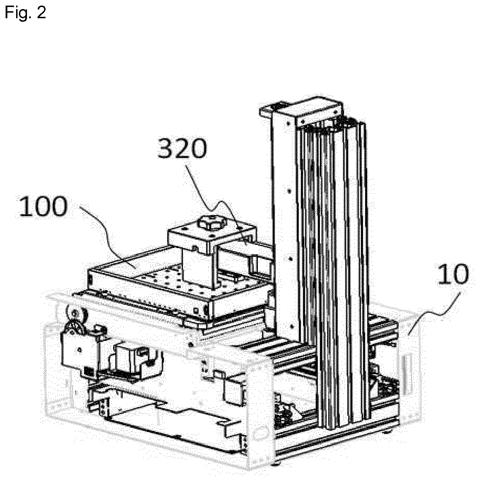

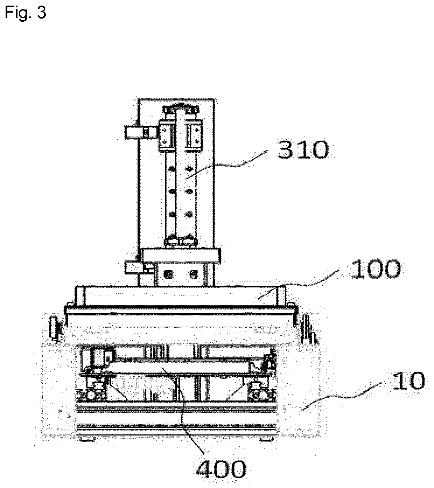

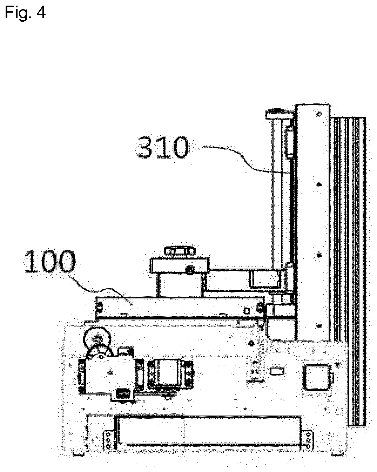

Referring to FIGS. 1 to 4, a 3D printer having a cooling function according to the present disclosure includes a tank 100 configured to store a photocurable liquid resin therein, a bed 200 configured to support a molded object thereon within the tank 100, a bed transfer unit 300 configured to transfer the bed 200, a light projection unit 400 configured to project laser light to the photocurable liquid resin so as to cure the photocurable liquid resin into a shaping object, a light projection unit transfer unit 500 configured to move the light projection unit 400, and a control unit 600 configured to control the operation of the light projection unit 400, the light projection unit transfer unit 500, and the bed transfer unit 300.

The tank 100 is installed on the upper portion of a main body frame 10, and stores a photocurable liquid resin therein.

The bed 200 serves to support a molded object, i.e., a 3D object, which is produced by curing the photocurable liquid resin by laser light. The bed 200 is configured to be movable in a vertical direction within the tank 100 by the bed transfer unit 300.

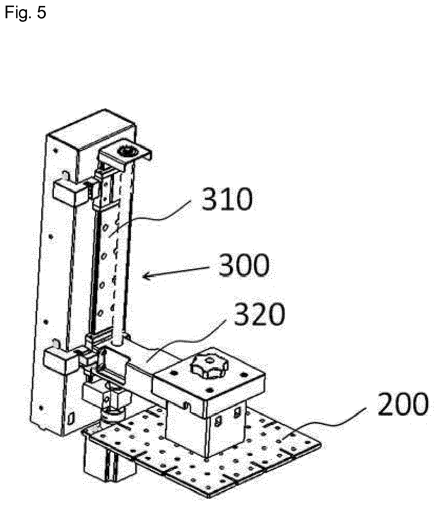

The bed transfer unit 300 includes a vertical transfer rail 310 and a transfer member 320 movable in the vertical direction along the vertical transfer rail 310. The vertical transfer rail 310 is vertically installed on one side surface of the main body frame 10. One end of the transfer member 320 is configured to be vertically movable along the vertical transfer rail 310 and the other end of the transfer member 320 is engaged with the bed 200 so as to move the bed 200 in the vertical direction (see FIG. 5).

The light projection unit 400 projects laser light according to a pattern set in the photocurable liquid resin stored in the tank 100 so as to cure the photocurable liquid resin into a three-dimensional molded object. Here, the light projection unit 400 is configured to project the laser light linearly in a longitudinal direction of the tank 100 and to be movable in a width direction of the tank 100 by the light projection unit transfer unit 500.

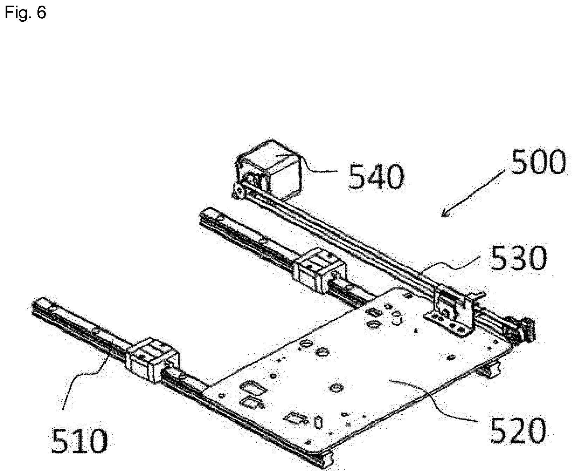

The light projection unit transfer unit 500 includes horizontal transfer rails 510 and a moving plate 520 movable in a horizontal direction, i.e. in the width direction of the tank 100 along the horizontal transfer rail 510. The horizontal transfer rails 510 are horizontally installed along the left and right surfaces of the main body frame 10. The moving plate 520 is installed between a pair of horizontal moving rails 510 and moves along the horizontal moving rails 510 by a gear motor 540 connected to a driving belt 530. In addition, a light projection unit 400 is fixed on the upper surface of the moving plate 520 (see FIG. 6).

The control unit 600 is installed on the left surface of the body frame 10 and controls the operations of the light projection unit 400, the light projection unit transfer unit 500, and the bed transfer unit 300 on the basis of data concerning an inputted molded object such that the inputted molded object is generated.

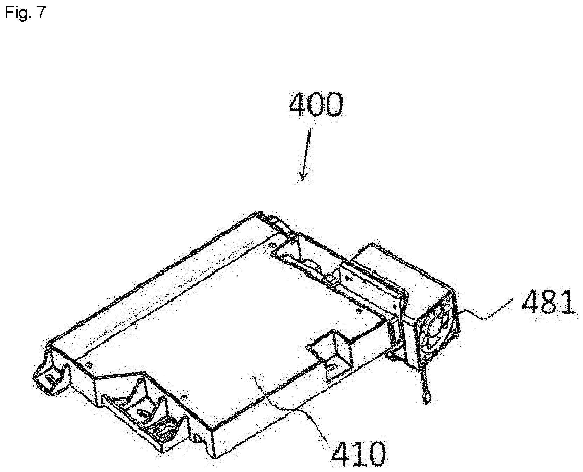

Referring to FIGS. 7 to 9, the light projection unit 400 includes a light projection unit main body 410 having a predetermined space therein, a laser diode 420 installed inside the light projection unit main body 410, a polygon mirror 430, and a refraction mirror 440.

The light projection unit main body 410 is fixed on a moving plate 520 of the light projection unit transfer unit 500 and moves in the width direction of the tank 100 together with the moving plate 520.

The laser diode 420 is embedded in the light projection unit main body 410 and projects laser light in a direction in which the polygon mirror 430 is installed. Here, the laser diode 420 projects ultraviolet light having a wavelength of about 350 to 420 nm and an output of about 600 to 1000 mW.

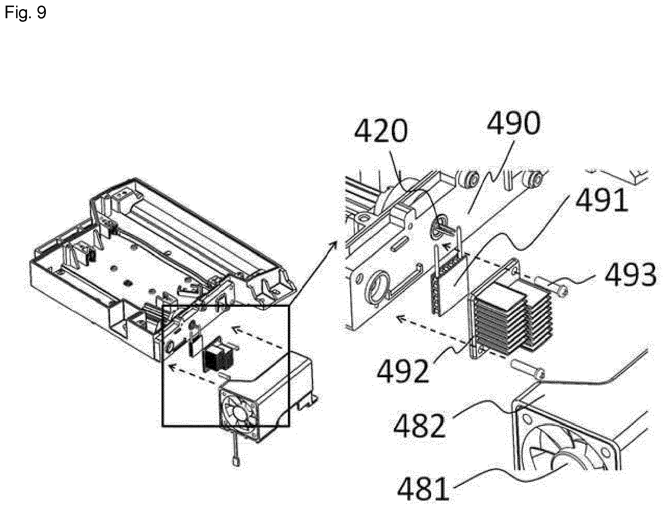

The polygon mirror 430 is embedded in the light projection unit main body 410 and reflects the laser light projected from the laser diode 420 while being rotated by a motor 431. Here, the polygon mirror 430 includes six reflection surfaces, and the motor 431 rotates the polygon mirror 430 at a speed of 20,000 to 43,000 rpm. Here, the polygon mirror 430 is installed in the light projection unit main body 410 such that the rotation axis of the polygon mirror 430 is perpendicular to the surface of the liquid resin filled in the tank 100. Therefore, the rotation plane of the polygon mirror 430 is disposed parallel to the surface of the liquid resin. The laser light reflected from the polygon mirror 430 is linearly reflected in the longitudinal direction of the tank 100 as illustrated in FIG. 9 by the rotation of the polygon mirror 430.

Meanwhile, a plurality of laser diodes 420 may be provided and spaced apart from each other at a predetermined interval in a circumferential direction around one point R of a reflection surface of the polygon mirror 430. The laser diodes 420 project laser light such that the laser light is superimposed on one point on a reflection surface of the polygon mirror 430, and thus the output of the laser light projected to the photocurable resin in the tank 100 through a reflection surface increases such that the photo-curing shaping speed is increased in proportion to the output of the laser light.

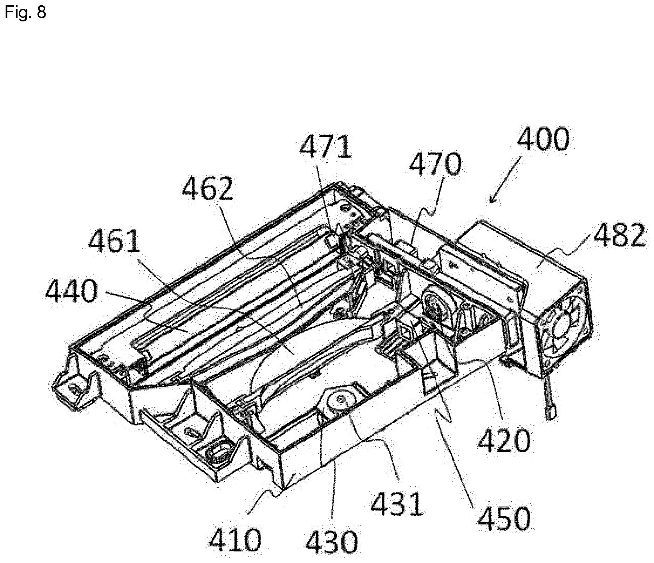

As illustrated in FIG. 8, the refraction mirror 440 is provided inside the light projection unit 400 and serves to refract the laser light reflected from the polygon mirror 430 toward the photocurable liquid resin inside the tank 100.

With this configuration, high-output and short-wavelength laser light projected from the laser diode 420 is reflected by the polygon mirror 430 to form a linear laser beam L in the longitudinal direction of the tank 100, and the laser light can be projected onto a 2D plane while horizontally moving the light projection unit 400. In addition, a 3D shaping object can be shaped by projecting laser beam to the 3D shaping object while vertically moving the bed 200.

Here, the photocurable-resin-shaping-type 3D printer according to the present disclosure is configured such that the laser light projected from the light projection unit 400 is reflected from the polygon mirror 430 having a rotating plane which is parallel to the surface of the liquid resin stored in the tank 100 and moves in the horizontal direction while forming a linear laser beam. Thus, it is possible to simplify the structure of the apparatus, compared with the conventional type in which X-Y axis control is performed on the galvanometer mirror, it is possible to improve the rotation quality and life of the polygon mirror, compared with the conventional type using a polygon mirror having a rotation plane disposed in an inclined or perpendicular direction with respect to the surface of the liquid resin, and it is possible to reduce the projecting time of laser light and thus to reduce the shaping time of a 3D object. In addition, it is possible to implement a control unit 600 with a simple configuration since only the light projection unit transfer unit 500 and the bed transfer unit 300 are controlled.

Preferably, the light projection unit 400 may include lenses 450, 461, and 462 (e.g., a cylindrical lens 450, a first F-θ lens 461, and a second F-θ lens 462) so as to condense the laser beam projected from the laser diode 420.

The cylindrical lens 450 is installed between the laser diode 420 and the polygon mirror 430 and condenses the laser light on a reflection surface of the polygon mirror 430 in the vertical direction. The first F-θ lens 461 is installed between the polygon mirror 430 and the refraction mirror 440 and condenses the laser light reflected from a reflection surface of the polygon mirror 430 toward the tank. The second F-θ lens 462 is installed between the first F-θ lens 461 and the refraction mirror 440 and condenses the laser light reflected from a reflection surface of the polygon mirror 430 toward the tank. Here, the first F-θ lens 461 and the second F-θ lens 462 are constituted by one set of two lenses, and thus the condensed laser light has a size of Ø 0.05 to Ø 0.1 mm.

The light projection unit 400 may further include a beam-detecting sensor 470 and a beam-detecting mirror 471 such that the control unit 600 is capable of determining an output start position of image data of a shaping object.

The beam detecting sensor 470 receives laser the light reflected from the polygon mirror 430 and transmits light-receiving information to the control unit 600. The beam detecting mirror 471 reflects the laser light reflected from the polygon mirror 430 toward the beam-detecting sensor 470. Then, the control unit 600 determines the output start position of the image data of the shaping object on the basis of the light-receiving information received from the beam-detecting sensor 470. That is, the control unit 600 serves to synchronize the resists of respective shaping layers.

Meanwhile, since the laser diode 420, which is a light source of the light projection unit, generates heat due to the high output thereof, the performance thereof cannot be maintained unless cooling and heat dissipation are not performed thereon properly. For this reason, the 3D printer having a cooling function according to the present disclosure has a configuration for the cooling function.

Specifically, the laser diode 420 is press-fitted to a plate 490 on one side of the light projection unit main body 410 in order to dissipate heat generated from the light projection unit 400. Thus, it is necessary for the plate 490 to be made of a metal material, rather than a plastic material. The plate 490 on the one side of the light projection unit main body 410 is provided with a heat dissipation fan 482 in order to cool the laser diode 420. Here, it has been confirmed that an air-cooling method using the heat dissipation fan 482 has no significant problem in a room-temperature environment. However, in a high-temperature environment of about 28 to 30°C, it is impossible to achieve sufficient cooling only with the heat dissipation fan 482. In order to compensate for the cooling effect of the heat dissipation fan 482, the 3D printer having a cooling function according to the present disclosure may further include a Peltier thermoelectric element 491 installed between the plate 490 of the light projection unit main body 410 and the heat dissipation fan 482. The Peltier thermoelectric element 491 is attached to the plate 490 and is capable of absorbing heat transmitted to the plate 490 through an endothermic reaction. In addition, a heat sink 492 is provided on the other side of the Peltier thermoelectric element 491, that is, between the Peltier thermoelectric element 491 and the heat dissipation fan 482. Accordingly, one side surface of the Peltier thermoelectric element 491 is attached to the plate 490 so as to absorb heat and the other side surface of the Peltier thermoelectric element 491 is brought into close contact with the heat sink 492 to discharge the heat dissipated from the plate 490. At this time, the heat of the heat sink 492 may be discharged to the outside through the heat dissipation fan 482.

Meanwhile, the heat sink 492 is fixed to the plate 490 through bolts 493, which may be made of a plastic material rather than a metal for effective heat dissipation. In fact, when the bolts 493 are made of a metal material, the heat from the heat sink 492 may be transferred to the plate 490 side, which results in a reduction in heat dissipation effect. However, when the bolts 493 are made of a plastic material, it is possible to block the heat from the heat sink 492 from being transferred to the plate 490 side, and thus it is possible to improve the cooling performance by about 2°C.

## Claims

1. A 3D printer having a cooling function, the 3D printer comprising:
a tank (100) configured to store therein a photocurable liquid resin;
a bed (200) configured to be moveable in a vertical direction within the tank (100) and to support a shaping object;
a bed transfer unit (300) configured to move the bed (200) in the vertical direction;
a light projection unit (400) configured to linearly project laser light to the photocurable liquid resin stored in the tank (100) in a longitudinal direction of the tank (100) so as to cure the photocurable liquid resin into the shaping object;
a light projection unit transfer unit (500) configured to move the light projection unit (400) in a width direction of the tank (100);
a control unit (600) configured to control operations of the light projection unit (400), the light projection unit transfer unit (500), and the bed transfer unit (300); and
a cooling unit installed on one side of the light projection unit (400) and configured to dissipate heat generated from the light projection unit (400),
the light projection unit (400) comprising:
a light projection unit main body (410) fixed to the light projection unit transfer unit (500) so as to be transferred in the width direction of the tank (100);
a laser diode (420) embedded in the light projection unit main body (410) and configured to project laser light in one direction;
a polygon mirror (430) embedded in the light projection unit main body (410) and configured to linearly reflect the laser light projected from the laser diode (420) in the longitudinal direction of the tank (100) while rotating; and
a refraction mirror (440) installed within the light projection unit main body (410) and configured to refract the laser light reflected from the polygon mirror (430) to the photocurable liquid resin within the tank (100),
the polygon mirror (430) comprising a rotation shaft disposed perpendicular to a surface of the liquid resin within the tank (100) so as to have a rotation plane parallel to the surface of the liquid resin.

2. The 3D printer of claim 1, wherein the light projection unit further comprises:
a cylindrical lens (450) configured to condense the laser light projected from the laser diode (420) on a reflection surface of the polygon mirror (430);
a first F-θ lens (461) installed between the polygon mirror (430) and the refraction mirror (440) and configured to condense the laser light reflected from a reflection surface of the polygon mirror (430) toward the tank; and
a second F-θ lens (462) installed between the first F-θ lens (461) and the refraction mirror (440) and configured to condense the laser light reflected from a reflection surface of the polygon mirror (430) toward the tank.

3. The 3D printer of claim 1, wherein the light projection unit (400) further comprises:
a beam-detecting sensor (470) configured to receive the laser light reflected from the polygon mirror (430) so as to determine an output start position of image data of the shaping object; and
a beam-detecting mirror (471) configured to reflect the laser light reflected from the polygon mirror (430) to the beam-detecting sensor (470).

4. The 3D printer of claim 1, wherein a plurality of laser diodes are provided so as to be spaced apart from each other at a predetermined interval in a circumferential direction around one point of the polygon mirror (430), and the plurality of laser diodes projects laser light such that the laser light is superimposed on the one point of the polygon mirror (430).

5. The 3D printer of claim 1, wherein the cooling unit comprises a heat dissipation fan (482) provided on a plate (490) on one side of the light projection unit main body (410) and a Peltier thermoelectric element (491) provided between the plate (490) and the heat dissipation fan (482) and configured to absorb heat from the plate (490) and to discharge heat through the heat dissipation fan (482).

6. The 3D printer of claim 5, wherein the cooling unit further comprises a heat sink (492) installed between the Peltier thermoelectric element (491) and the heat dissipation fan (482), and the heat sink (492) is fixed onto the plate (490) by a bolt made of a plastic material, and the plate (490) is made of a metal material.

## Patentansprüche

1. 3D-Drucker mit Kühlfunktion, wobei der 3D-Drucker folgendes aufweist:
einen Tank (100), der dazu ausgelegt ist, darin ein durch Licht härtbares flüssiges Harz zu lagern,
eine Unterlage (200), die dazu ausgelegt ist, im Tank (100) in einer senkrechten Richtung bewegbar zu sein und ein zu formendes Objekt zu tragen,
eine Unterlagenverlagerungseinheit (300), die dazu ausgelegt ist, die Unterlage (200) in der senkrechten Richtung zu bewegen,
eine Lichtprojektionseinheit (400), die dazu ausgelegt ist, Laserlicht linear auf das im Tank (100) gelagerte, durch Licht härtbare flüssige Harz in einer Längsrichtung des Tanks (100) zu richten, um das durch Licht härtbare flüssige Harz zum zu formenden Objekt zu härten;
eine Verlagerungseinheit (500) für die Lichtprojektionseinheit, die dazu ausgelegt ist, die Lichtprojektionseinheit (400) in einer Breitenrichtung des Tanks (100) zu bewegen,
eine Steuerungseinheit (600), die dazu ausgelegt ist, Vorgänge der Lichtprojektionseinheit (400), der Verlagerungseinheit (500) für die Lichtprojektionseinheit und der Unterlagenverlagerungseinheit (300) zu steuern, und
eine auf einer Seite der Lichtprojektionseinheit (400) angebrachte Kühleinheit, die dazu ausgelegt ist, von der Lichtprojektionseinheit (400) erzeugte Wärme abzuleiten,
aufweist;
wobei die Lichtprojektionseinheit (400)
einen Lichtprojektionseinheitshauptkörper (410), der an der Verlagerungseinheit (500) für die Lichtprojektionseinheit angebracht ist, um in der Breitenrichtung des Tanks (100) bewegt zu werden,
eine Laserdiode (420), die im Lichtprojektionseinheitshauptkörper (410) eingebettet ist und dazu ausgelegt ist, Laserlicht in einer Richtung auszusenden, einen polygonalen Spiegel (430), der im Lichtprojektionseinheitshauptkörper (410) eingebettet ist und dazu ausgelegt ist, das von der Laserdiode (420) ausgesandte Laserlicht in einer Längsrichtung des Tanks (100) linear zu reflektieren und sich dabei zu drehen, und
einen Refraktionsspiegel (440), der im Lichtprojektionseinheitshauptkörper (410) eingebettet ist und dazu ausgelegt ist, das vom polygonalen Spiegel (430) zum durch Licht härtbaren flüssigen Harz reflektierte Laserlicht im Tank (100) zu brechen,
aufweist,
wobei der polygonale Spiegel (430) eine zu einer Oberfläche des flüssigen Harzes im Tank (100) senkrechte Drehachse aufweist, um eine zur Oberfläche des flüssigen Harzes parallele Drehebene zu haben.

2. 3D-Drucker gemäß Anspruch 1, **dadurch gekennzeichnet, daß** die Lichtprojektionseinheit außerdem
eine zylindrische Linse (450), die dazu ausgelegt ist, das von der Laserdiode (420) ausgesandte Laserlicht auf einer Reflexionsoberfläche des polygonalen Spiegels (430) zu bündeln,
eine erste F-Θ Linse (461), die zwischen dem polygonalen Spiegel (430) und dem Reflexionsspiegel (440) angebracht ist und dazu ausgelegt ist, das von einer Reflexionsoberfläche des polygonalen Spiegels (430) zum Tank reflektierte Laserlicht zu bündeln, und
eine zweite F-Θ Linse (462), die zwischen der ersten F-Θ Linse (461) und dem Refraktionsspiegel (440) angebracht ist und dazu ausgelegt ist, das von einer Reflexionsoberfläche des polygonalen Spiegels (430) zum Tank reflektierte Laserlicht zu bündeln,
aufweist.

3. 3D-Drucker gemäß Anspruch 1, **dadurch gekennzeichnet, daß** die Lichtprojektionseinheit (400) außerdem
einen Strahlerkennungssensor (470), der dazu ausgelegt ist, das vom polygonalen Spiegel (430) reflektierte Laserlicht zu empfangen, um eine Ausgabestartposition von Bilddaten des zu formenden Objekts zu bestimmen, und
einen Strahlerkennungssensor (471), der dazu ausgelegt ist, das vom polygonalen Spiegel (430) reflektierte Laserlicht zum Strahlerkennungssensor (470) zu reflektieren,
aufweist.

4. 3D-Drucker gemäß Anspruch 1, **dadurch gekennzeichnet, daß** eine Anzahl Laserdioden so angeordnet ist, daß sie in einer Umfangsrichtung um einen Punkt des polygonalen Spiegels (430) herum einen vorbestimmten Abstand voneinander aufweisen und daß die Anzahl Laserdioden Laserlicht so aussendet, daß sich das Laserlicht in dem einen Punkt des polygonalen Spiegels (430) überlagert.

5. 3D-Drucker gemäß Anspruch 1, **dadurch gekennzeichnet, daß** die Kühleinheit einen Wärmeabfuhrlüfter (482), der auf einer Platte (490) auf einer Seite des Lichtprojektionseinheitshauptkörpers (410) angeordnet ist, und ein thermoelektrisches Peltier-Element (491), das zwischen der Platte (490) und dem Wärmeabfuhrlüfter (482) angeordnet ist und dazu ausgelegt ist, Wärme von der Platte (490) aufzunehmen und Wärme mittels des Wärmeabfuhrlüfters (482) abzuführen, aufweist.

6. 3D-Drucker gemäß Anspruch 5, **dadurch gekennzeichnet, daß** die Kühleinheit außerdem einen zwischen dem thermoelektrischen Peltier-Element (491) und dem Wärmeabfuhrlüfter (482) angebrachten Kühlkörper (492) aufweist und daß der Kühlkörper (492) mittels eines aus einem Plastikmaterial gefertigten Bolzens auf der Platte (490) befestigt ist und die Platte (490) aus einem metallenen Material gefertigt ist.

## Revendications

1. Imprimante 3D ayant une fonction refroidissement, l'imprimante 3D comprenant :
un réservoir (100) configuré pour y stocker une résine liquide photodurcissable ;
un lit (200) configuré pour être mobile dans une direction verticale à l'intérieur du réservoir (100) et pour supporter un objet en formation ;
une unité de transfert de lit (300) configurée pour déplacer le lit (200) dans la direction verticale ;
une unité de projection de lumière (400) configurée pour projeter de manière linéaire une lumière laser sur la résine liquide photodurcissable stockée dans le réservoir (100) dans une direction longitudinale du réservoir (100), de façon à durcir la résine liquide photodurcissable en l'objet en formation ;
une unité de transfert d'unité de projection de lumière (500) configurée pour déplacer l'unité de projection de lumière (400) dans une direction de la largeur du réservoir (100) ;
une unité de commande (600) configurée pour commander les opérations de l'unité de projection de lumière (400), de l'unité de transfert d'unité de projection de lumière (500) et de l'unité de transfert de lit (300) ; et
une unité de refroidissement installée sur un côté de l'unité de projection de lumière (400) et configurée pour dissiper la chaleur générée par l'unité de projection de lumière (400),
l'unité de projection de lumière (400) comprenant :
un corps principal d'unité de projection de lumière (410) fixé sur l'unité de transfert d'unité de projection de lumière (500) de façon à être transféré dans la direction de la largeur du réservoir (100) ;
une diode laser (420) intégrée dans le corps principal d'unité de projection de lumière (410) et configurée pour projeter une lumière laser dans une direction ;
un miroir polygonal (430) intégré dans le corps principal d'unité de projection de lumière (410) et configuré pour réfléchir de manière linéaire la lumière laser projetée par la diode laser (420) dans la direction longitudinale du réservoir (100) tout en tournant ; et
un miroir de réfraction (440) installé dans le corps principal d'unité de projection de lumière (410) et configuré pour réfracter la lumière laser réfléchie par le miroir polygonal (430) sur la résine liquide photodurcissable à l'intérieur du réservoir (100),
le miroir polygonal (430) comprenant un arbre de rotation disposé perpendiculairement à une surface de la résine liquide dans le réservoir (100) de façon à avoir un plan de rotation parallèle à la surface de la résine liquide.

2. Imprimante 3D selon la revendication 1, dans lequel l'unité de projection de lumière comprend en outre :
une lentille cylindrique (450) configurée pour condenser la lumière laser projetée par la diode laser (420) sur une surface réfléchissante du miroir polygonal (430) ;
une première lentille F-θ (461) installée entre le miroir polygonal (430) et le miroir de réfraction (440) et configurée pour condenser la lumière laser réfléchie par une surface réfléchissante du miroir polygonal (430) en direction du réservoir ; et
une deuxième lentille F-θ (462) installée entre la première lentille F-θ (461) et le miroir de réfraction (440) et configurée pour condenser la lumière laser réfléchie par une surface réfléchissante du miroir polygonal (430) en direction du réservoir.

3. Imprimante 3D selon la revendication 1, dans lequel l'unité de projection de lumière (400) comprend en outre :
un capteur de détection de faisceau (470) configuré pour recevoir la lumière laser réfléchie par le miroir polygonal (430) de façon à déterminer une position de départ de sortie de données d'image de l'objet en formation ; et
un miroir de détection de faisceau (471) configuré pour réfléchir la lumière laser réfléchie par le miroir polygonal (430) sur le capteur de détection de faisceau (470).

4. Imprimante 3D selon la revendication 1, dans lequel une pluralité de diodes laser sont prévues, de manière à être espacées les unes des autres d'un intervalle prédéterminé dans une direction circonférentielle autour d'un point du miroir polygonal (430), et la pluralité de diodes laser projette la lumière laser de telle sorte que la lumière laser soit superposée sur ledit point du miroir polygonal (430).

5. Imprimante 3D selon la revendication 1, dans lequel l'unité de refroidissement comprend un ventilateur de dissipation de chaleur (482) prévu sur une plaque (490) sur un côté du corps principal de l'unité de projection de lumière (410) et un élément thermoélectrique de Peltier (491) prévu entre la plaque (490) et le ventilateur de dissipation de chaleur (482) et configuré pour absorber la chaleur de la plaque (490) et décharger la chaleur à travers le ventilateur de dissipation de chaleur (482).

6. Imprimante 3D selon la revendication 5, dans lequel l'unité de refroidissement comprend en outre un dissipateur de chaleur (492) installé entre l'élément thermoélectrique de Peltier (491) et le ventilateur de dissipation de chaleur (482), et le dissipateur de chaleur (492) est fixé sur la plaque (490) par un boulon en matière plastique, et la plaque (490) est faite d'un matériau métallique.
